# FASCICULE DE BREVET EUROPEEN

(11) **EP 1 193 802 B1**
(45) Date de publication et mention de la délivrance du brevet: **24.01.2007**
(21) Numéro de dépôt: 01402403.8
(22) Date de dépôt: 19.09.2001
(51) Int. Cl.: H01R 12/22

(54) **Connecteur à ressort pour la connexion électrique de pistes d'un écran d'affichage avec un circuit électrique**
Federsteckverbinder zur Verbindung einer Leiterplatte mit einem Bildschirm
Spring connector for connecting a display to a printed circuit board

(30) Priorité: 02.10.2000 FR 0012509
(43) Date de publication de la demande: 03.04.2002
(73) Titulaire: TCL & ALCATEL MOBILE PHONES LIMITED, China Hong Kong City, 33 Canton Road, Tsim Sha Tsui,Kowloon, Hong Kong (CN)
(72) Inventeur: Villain, Jean-Christophe, 92700 Colombes (FR); Vogel, Frédéric, 92600 Asnieres sur Seine (FR); Cupif, Bertrand, 92160 Antony (FR)
(74) Mandataire: Feray, Valérie

(56) Documents cités:
- JP-A- 1 293 592
- US-A- 4 738 625
- US-A- 5 436 744
- US-A- 5 737 053
- US-A- 5 938 455

## Description

L'invention se rapporte à un connecteur à ressort pour la connexion électrique d'au moins une piste d'un écran d'affichage avec un circuit électrique. Elle se rapporte également à un système d'affichage comprenant un tel connecteur à ressort, ainsi qu'à un terminal comprenant le système d'affichage.

On connaît du document WO-99/00877 un connecteur à ressort métallique apte à connecter électriquement les pistes d'un écran d'affichage, du type LCD (afficheur à cristaux liquides), aux pistes d'un circuit imprimé. Ce connecteur a également pour fonction de maintenir l'écran d'affichage.

Or les afficheurs LCD sont recouverts d'une matière (tel que l'ITO : Indium Tin Oxyde) fragile et donc facilement rayable par un connecteur métallique du type précité.

Une autre solution de l'art antérieur consiste à intercaler un connecteur souple entre d'une part les pistes de l'afficheur LCD et d'autre part les pistes du circuit imprimé. Le connecteur est ainsi positionné en pression entre l'écran et le circuit. Un tel montage n'est pas simple et en cas de mauvaise fixation, la connexion peut ne pas être assurée. Par ailleurs la force exercée sur le circuit est trop élevée et la course du connecteur est trop faible pour assurer une connexion fiable. Le document US-A-4738625 décrit un connecteur selon le préambule de la revendication 1. L'invention a donc pour but de pallier les inconvénients de l'art antérieur. Elle propose ainsi un connecteur apte à non seulement connecter un afficheur à un circuit imprimé, de manière sûre et efficace, sans rayure possible de la matière recouvrant l'écran d'affichage, mais également à maintenir l'afficheur en position. Le connecteur pouvant en outre être facilement monté et démonté.

A cet effet, l'invention se rapporte à un connecteur du type précité, comprenant des moyens de maintien pour maintenir en position l'écran d'affichage ; une feuille métallique souple, formant ressort ; et un film plastique comportant au moins une piste électrique, et ayant sensiblement la même forme que la feuille métallique. Le film plastique est fixé à l'une des faces de la feuille métallique, au moins l'une de ses pistes étant destinée à connecter les pistes de l'écran d'affichage avec le circuit électrique.

Le connecteur à ressort présente sensiblement une forme de "S", dont la partie supérieure forme les moyens de maintien en position de l'écran d'affichage.

L'invention se rapporte en outre à un système d'affichage comprenant un écran d'affichage comportant au moins une piste électrique et un circuit électrique pour commander l'écran d'affichage, l'écran d'affichage et le circuit électrique étant disposés sensiblement en regard l'un de l'autre. Ce système comprend en outre un connecteur à ressort du type précité.

Enfin, l'invention se rapporte à un terminal comportant ce système d'affichage ainsi que des moyens de support de l'écran d'affichage et du circuit électrique, et des moyens pour maintenir l'écartement entre l'écran d'affichage et le circuit électrique.

L'invention sera mieux comprise à la lumière de la description qui suit en référence aux dessins annexés.

La figure 1 est une vue schématique en coupe transversale du système d'affichage de l'invention.

La figure 2 est une vue schématique partielle du système d'affichage de la figure 1, selon la vue II.

La figure 3 représente une vue en coupe transversale du connecteur à ressort de l'invention.

Les figures 4a et 4b sont des vues en perspective, respectivement de dessus et de dessous, du film plastique du connecteur à ressort, lorsqu'il est plié.

Les figures 5a et 5b sont des vues en perspective, respectivement de dessus et de dessous, de la feuille métallique du connecteur à ressort, lorsqu'il est plié.

La figure 6 est une vue en perspective de dessus du connecteur à ressort, comportant la feuille métallique et le film assemblés.

La figure 7 représente une vue en plan du film plastique déplié, montrant les pistes qu'il comporte.

Les figures 8a et 8b sont des vues en perspective, respectivement de dessous, de dessus, montrant l'écran d'affichage, le connecteur à ressort et le circuit imprimé désassemblés.

La figure 9 est une vue similaire à la figure 8b, l'écran d'affichage et le connecteur à ressort étant assemblés.

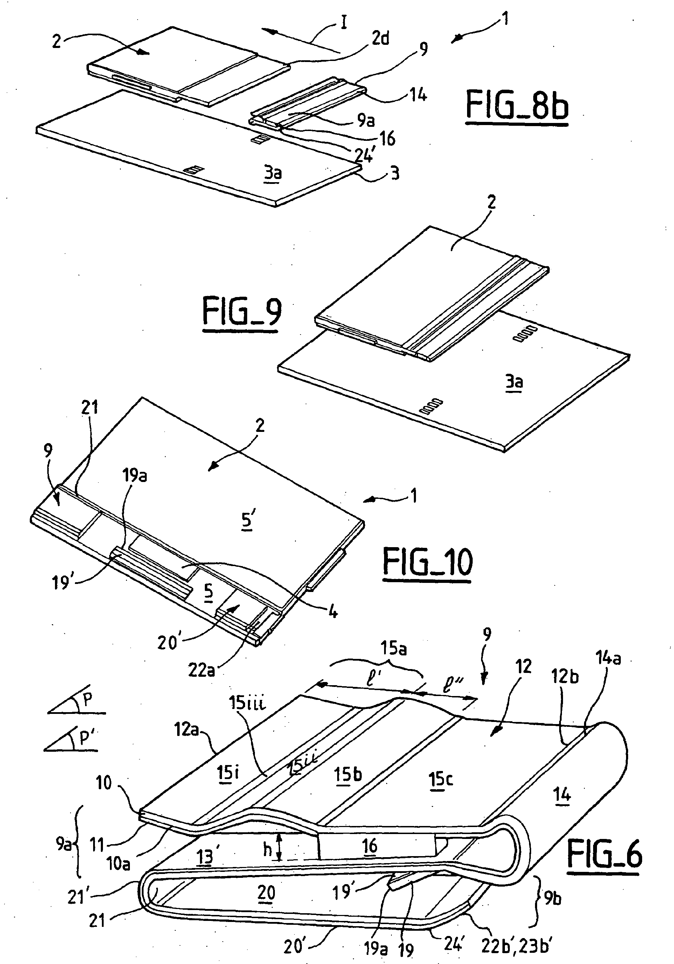

Enfin, la figure 10 montre, en perspective, de dessous, l'écran d'affichage connecté au circuit intégré au moyen du connecteur à ressort.

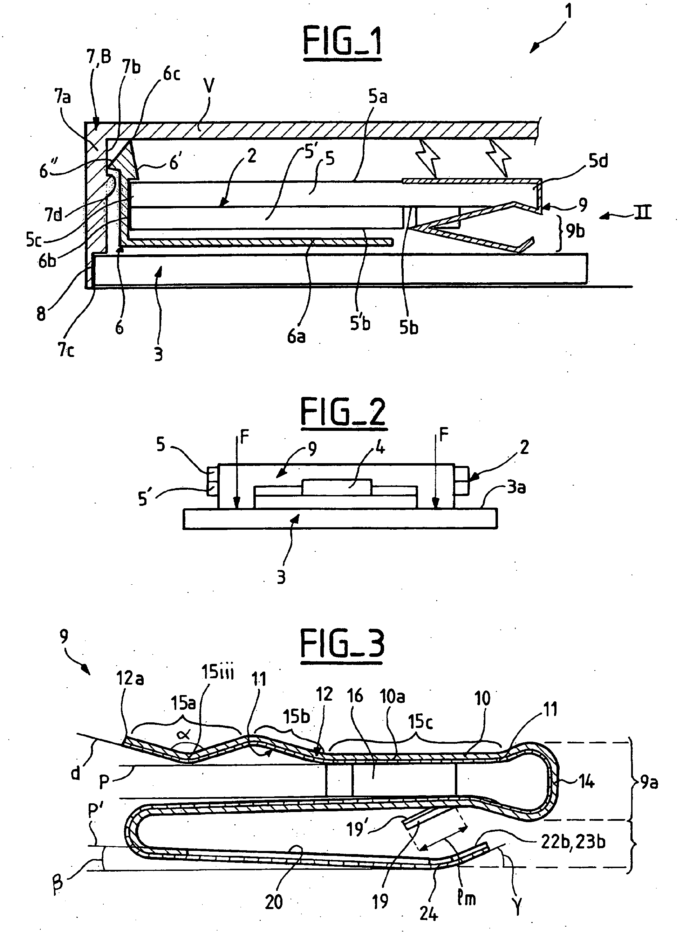

En référence à la figure 1, le système d'affichage 1 comporte un écran d'affichage 2 s'étendant sensiblement parallèlement, en regard et écarté d'un circuit imprimé 3.

L'écran d'affichage 2 est un écran à cristaux liquides (LCD) composé, dans le présent exemple de réalisation, d'une première et d'une deuxième plaques de verre, respectivement 5, 5', enfermant entre elles le cristal liquide.

La première plaque de verre 5 présente une forme générale parallélépipédique, définissant deux faces principales, sensiblement rectangulaires, respectivement supérieure 5a et inférieure 5b. La face principale inférieure 5b s'étend en regard du circuit imprimé 3.

Les deux faces principales 5a, 5b forment, respectivement vers chacune de leurs extrémités libres situées vers leurs petits côtés, respectivement un bord de fixation 5c et un bord de connexion 5d de l'écran d'affichage 2. Ces deux bords 5c, 5d sont opposés l'un à l'autre.

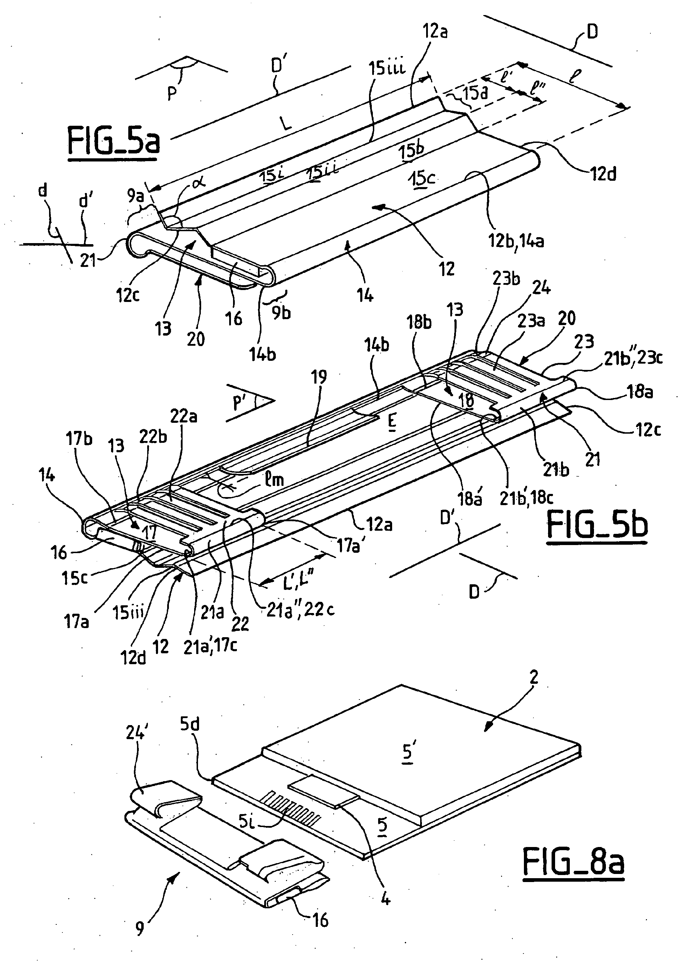

Au moins la face principale inférieure 5b comporte des pistes électriques 5i (figure 8a) reliant les composants constituant l'écran d'affichage 2 à un dispositif de commande 4 dudit écran, couramment appelé « driver ». Les pistes électriques 5i s'étendent à partir du bord de connexion 5d.

Dans le mode de réalisation représenté, le dispositif de commande 4 est fixé rigidement à la face principale inférieure 5b, du côté du bord de connexion 5d.

La deuxième plaque de verre 5' est fixée rigidement à la face principale inférieure 5b de la première plaque de verre 5. Elle s'étend depuis le bord de fixation 5c jusque, sensiblement au dispositif de commande 4.

Suivant une autre réalisation, on pourrait envisager que le dispositif de commande 4 soit fixé à la deuxième plaque de verre 5'.

Le circuit imprimé 3 se présente classiquement sous la forme d'une carte dont une face 3a comporte les composants nécessaires notamment à la transmission d'informations à afficher sur l'écran d'affichage 2. Cette face 3a s'étend en regard de la face principale inférieure 5b.

Le système d'affichage 1 comporte un dispositif de support 6 pour supporter l'écran d'affichage 2 ainsi qu'un dispositif d'écartement 7 pour maintenir l'écran d'affichage 1 à la distance voulue du circuit imprimé 3.

Dans la réalisation représentée, le dispositif de support 6 est formé de deux parois sensiblement perpendiculaires 6a, 6b, reliées entre elles par une de leurs extrémités. Comme le montre la figure 1, le dispositif de support 6 présente, en coupe transversale, sensiblement une forme de « L ».

La paroi 6a s'étend sensiblement parallèlement et le long de la face principale inférieure 5'b de la deuxième plaque de verre 5'. En outre, la paroi 6b s'étend à proximité du bord de fixation 5c, dans la direction opposée au circuit imprimé 3.

La paroi 6b comporte vers son extrémité libre 6c et du côté de l'écran d'affichage 2 une première butée 6'. Celle-ci est située par rapport à la paroi 6a de sorte que le bord de fixation 2c de l'écran d'affichage 2 ainsi que la partie du guide de lumière 5 qui lui est associée, soient maintenus entre la première butée 6' et la paroi 6a.

La paroi 6b comporte en outre vers son extrémité libre 6c et du côté opposé à l'écran d'affichage 2 une deuxième butée 6".

Le dispositif d'écartement 7 comprend une paroi 7a s'étendant sensiblement parallèlement à la paroi 6b du dispositif de support 6, du côté opposé à l'écran d'affichage 2.

Dans la réalisation représentée, le dispositif d'écartement 7 fait partie intégrante du boîtier B du terminal incorporant le système d'affichage 1. Ainsi, comme cela est représenté sur la figure 1, le boîtier B comprend une vitre V s'étendant sensiblement parallèlement et le long de la face principale supérieure 5a de l'écran d'affichage 2. La vitre V est attenante à la paroi 7a de sorte qu'elles forment entre elles, en coupe transversale, sensiblement une forme de "L".

La paroi 7a comporte vers son extrémité libre 7c, du côté opposé à la vitre V, des moyens de fixation 8 du circuit imprimé 3. Ces moyens de fixation 8 peuvent être réalisés de différentes manières et ne seront pas décrits plus en détail ici.

La paroi 7a comporte en outre, sur sa face intérieure 7b, qui est en regard avec le dispositif de support 6, un ergot 7d apte à venir en butée contre la deuxième butée 6". L'ergot 7d est distant de l'extrémité libre 7c de sorte que, lorsqu'il est en butée contre la deuxième butée 6", l'écran d'affichage 2 soit maintenu écarté du circuit imprimé 3. Dans la présente réalisation, cet écartement est de l'ordre de un millimètre, lorsque l'écran 2 s'étend sensiblement parallèlement au circuit imprimé 3.

Suivant une réalisation alternative, on peut envisager que l'écran 2 soit incliné par rapport au circuit imprimé 3. Dans ce cas, le bord de connexion 5d resterait écarté du circuit imprimé 3, d'une hauteur sensiblement similaire, tandis que le bord de fixation 5c serait relevé de sorte que l'écran d'affichage 2 forme avec le circuit imprimé 3 un angle inférieur ou égal à 45°. On décrit maintenant le connecteur à ressort 9 en référence aux figures 3 et 6.

Le connecteur 9 est formé d'une feuille métallique souple, formant ressort, 10 et d'un film plastique 11. La feuille métallique 10 et le film plastique 11 présentent, lorsqu'ils sont dépliés, une forme générale rectangulaire sensiblement identique.

Le film plastique 11 est fixé sur l'une des faces, appelée face extérieure 10a, de la feuille métallique 10. Dans la réalisation représentée, le film plastique 11 est collé, de manière rigide, bord à bord, avec la feuille métallique 10.

Lorsqu'il est mis en forme, par pliage des feuille métallique 10 et film plastique 11, le connecteur 9 présente, en coupe transversale, sensiblement une forme de "S".

La partie supérieure du « S » 9a est destinée à maintenir en position l'écran d'affichage 2, en formant pince sur le bord de connexion 5d, comme il sera expliqué plus loin. En outre la partie inférieure du « S » 9b est destinée à être en contact avec le circuit électrique 3.

On décrit maintenant plus précisément la forme de la feuille métallique 10 lorsqu'elle est dans sa position de « S », en référence aux figures 5a et 5b.

La partie supérieure du « S » 9a est formée d'une aile supérieure 12 et d'une aile médiane 13, reliées entre elles par une âme de maintien 14.

L'aile supérieure 12 et l'aile médiane 13 s'étendent en regard l'une de l'autre et sensiblement parallèlement l'une par rapport à l'autre, suivant un plan P. Elles présentent une largeur I - comptée suivant une direction D, - sensiblement identique. Il en est de même de leur longueur L - comptée suivant une direction D', perpendiculaire à D -.

L'aile supérieure 12 est délimitée par un bord frontal 12a, libre, opposé au bord de liaison 12b à partir duquel s'étend l'âme de maintien 14. Le bord frontal 12a et le bord de liaison 12b sont reliés entre eux, à chacune de leurs extrémités, par deux bords latéraux 12c, 12d. Les deux bords latéraux 12c, 12d s'étendent parallèlement l'un à l'autre suivant la direction D.

L'aile supérieure 12 est formée de trois portions attenantes 15a, 15b, 15c. Ces trois portions 15a, 15b, 15c s'étendent sur toute la longueur L, depuis le bord frontal 12a jusqu'au bord de liaison 12b.

La première portion 15a s'étend à partir du bord frontal 12a, sur une largeur l' - comptée selon la direction D - de l'ordre du quart de la largeur I. Elle présente, sur toute la longueur L, sensiblement une forme de « V », en coupe transversale. Cette première portion 15a a une fonction de chanfrein.

La première portion 15a est ainsi formée de :
- une première branche 15i délimitée par le bord frontal 12a et inclinée suivant une première direction d, par rapport au plan P, et
- une deuxième branche 15ii, attenante d'une part à la première branche 15i et d'autre part à la deuxième portion 15b, et inclinée suivant une deuxième direction d' par rapport au plan P.

Dans l'exemple représenté, l'angle α formé entre les deux branches 15i et 15ii est de l'ordre de 150°.

A cette première portion 15a, est attenante une deuxième portion 15b, s'étendant sur une largeur l" - comptée selon la direction D - de l'ordre du huitième de la largeur I. Cette deuxième portion 15b est inclinée par rapport au plan P suivant sensiblement la direction d. Elle a pour fonction le renforcement de l'aile supérieure 12.

Enfin, la deuxième portion 15b est suivie d'une troisième portion 15c plane, s'étendant sensiblement parallèlement au plan P. La troisième portion 15c est alignée avec la ligne d'intersection 15iii formée par les branches 15i et 15ii.

Cette troisième portion 15c comporte au moins une paroi formant guide 16 s'étendant sensiblement perpendiculairement au plan P et en direction de l'aile médiane 13. La paroi formant guide 16 est attenante à un bord latéral 12c, 12d. Elle présente une hauteur h (figure 6) - comptée perpendiculairement au plan P-inférieure ou égale à la distance séparant l'aile supérieure 12 de l'aile médiane 13.

Dans la présente réalisation, la troisième portion 15c comporte deux parois formant guide 16, s'étendant respectivement à partir de chaque bord latéral 12c, 12d et parallèles entre elles.

L'âme de maintien 14 s'étend sensiblement perpendiculairement aux ailes supérieure et médiane 12 et 13. Elle comporte deux bords longitudinaux 14a, 14b, sensiblement parallèles. L'un des bords longitudinaux 14a est attenant au bord de liaison 12b, tandis que l'autre 14b est attenant à l'aile médiane 13.

L'âme de maintien 14 présente, en coupe transversale, sensiblement une forme de « C » dont la concavité est tournée vers l'intérieur de la partie supérieure 9a. Cette forme permet d'augmenter l'élasticité du connecteur 9.

En référence à la figure 5b, l'aile médiane 13 est formée de deux parties d'extrémité 17, 18 sensiblement identiques et d'une partie formant lame 19. Les trois parties 17 à 19 sont respectivement attenantes au bord longitudinal 14b.

Les parties d'extrémité 17, 18 sont sensiblement planes et présentent chacune une longueur L' - comptée suivant la direction D' - de l'ordre du cinquième de la longueur L. Elles s'étendent dans un même plan, parallèle au plan P.

Chaque partie d'extrémité 17, 18 comporte deux bords latéraux libres, opposés et parallèles, respectivement 17a, 17a' et 18a, 18a'. Les bords latéraux 17a et 18a sont respectivement en regard des bords latéraux 12c et 12d de l'aile supérieure 12. En outre, les bords latéraux 17a' et 18a' sont en regard l'un de l'autre et séparés d'un espace E, occupé partiellement par la partie formant lame 19.

Chaque partie d'extrémité 17, 18 comporte en outre, sensiblement perpendiculairement aux bord latéraux, respectivement 17a, 17a' et 18a, 18a' :
- un bord 17b, 18b attenant à l'âme de maintien 14 et
- un bord de délimitation 17c, 18c délimitant la partie supérieure 9a.

La partie formant lame 19 est disposée entre les parties d'extrémité 17, 18 et écartée des bords latéraux 17a' et 18a'. Elle présente, sur toute sa longueur et en coupe transversale, sensiblement une forme de « V » inversé. Sa concavité est tournée du côté opposé de la partie supérieure 9a du connecteur 9. Par ailleurs, la partie formant lame 19 présente une largeur lₘ -comptée suivant la direction D- de l'ordre du quart de celle - comptée suivant la même direction - des parties d'extrémité 17, 18.

La partie inférieure du « S » 9b est formée de l'aile médiane 13 et d'une aile inférieure 20, reliées entre elles par une âme de liaison 21.

L'aile inférieure 20 et l'aile médiane 13 s'étendent généralement en regard l'une de l'autre. Elles présentent une largeur I - comptée suivant la direction D - sensiblement identique.

L'aile inférieure 20 est formée de deux parties formant contact 22, 23, distinctes, écartées, généralement planes et s'étendant dans un même plan P'. Le plan P' est sensiblement incliné par rapport au plan P de sorte que la partie inférieure 9b occupe, en hauteur, l'espace libre entre l'écran d'affichage 2 et le circuit imprimé 3. L'angle d'inclinaison β (figure 3) de l'aile inférieure est de l'ordre de 5°.

Chaque partie formant contact 22, 23 s'étend en regard d'une partie d'extrémité 17, 18. Elle présente une longueur L" - comptée suivant la direction D' - sensiblement égale à la longueur L' de chaque partie d'extrémité 17, 18.

Comme représenté sur la figure 5b, chaque partie formant contact 22, 23 présente une forme de peigne. Elle comporte des dents 22a, 23a, au nombre de quatre dans la présente réalisation, sensiblement parallèles les unes aux autres et s'étendant suivant la direction D, dans un même plan.

Il est à noter que la forme de peigne des parties formant contact 22, 23 permet une répartition des forces sur l'aile inférieure 20. Ceci peut être avantageux dans l'hypothèse où le circuit intégré 3, contre lequel elles vont être en contact, n'est pas exactement plan. Bien entendu, cette forme particulière n'est aucunement exclusive, d'autres réalisations pouvant être envisagées.

Comme cela est visible sur la figure 3 notamment, le bord libre 22b, 23b de chaque partie formant contact 22, 23 est incliné en direction de l'âme de maintien 14 suivant un angle γ - compté par rapport au plan P' - de l'ordre de 30°. Un point de contact 24 est ainsi formé, du côté opposé à l'aile médiane 13, à l'intersection entre le bord libre relevé 22b, 23b et la portion principale de la partie formant contact 22, 23.

L'âme de liaison 21 est formée de deux portions d'âme 21a, 21b sensiblement identiques et coplanaires. Chaque portions d'âme 21a, 21b présente, comme l'âme de maintien 14, une forme de « C » dont la concavité est tournée vers l'intérieur de la partie inférieure 9b.

Chaque portion d'âme 21a, 21b est attenante d'une part, par un de ses bords longitudinaux 21a', 21b' au bord de délimitation 17c, 18c et d'autre part, par l'autre de ses bords longitudinaux 21a", 21b", au bord 22c, 23c, qui est opposé au bord libre relevé 22b, 23b.

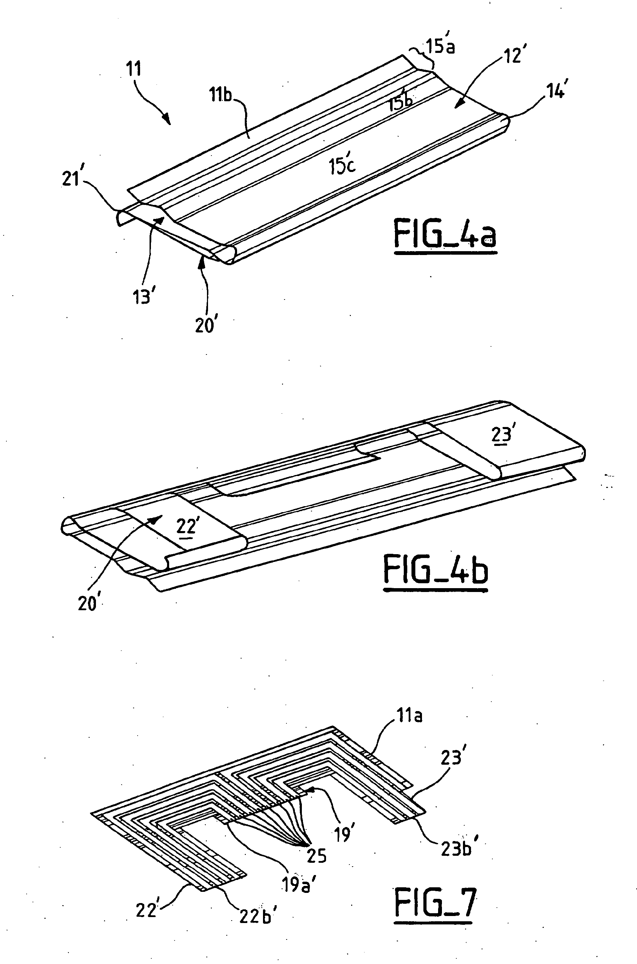

Comme représenté sur les figures 4a et 4b, le film plastique 11 présente sensiblement la même forme que la feuille métallique 10, lorsqu'elles sont repliées dans la forme du « S ». Les mêmes références que celles de la feuille métallique 10, suivies d'un « ' », sont donc utilisées.

La seule différence réside dans la forme de l'aile inférieure 20' du film plastique 11. En effet, celle-ci est formée de deux portions 22', 23' destinées à recouvrir respectivement les parties formant contact 22, 23 mais ne comportant pas de dents. Elles sont continues.

Cette forme permet de recouvrir entièrement les dents 22a, 23a de manière à assurer une bonne protection de celles-ci. Il pourrait néanmoins être envisagé, dans une autre réalisation, que les portions 22', 23' présentent également une forme de peigne.

Par ailleurs, la forme de l'une des portions 22' est telle que, lorsque le film plastique 11 recouvre la feuille métallique 10 sur une de ses faces, seule une dent 22a de la partie formant contact correspondante 22 n'est pas recouverte par le film plastique 11 (figures 4b et 10). Lorsque le connecteur 9 sera en place, cette dent 22a aura une fonction de contact de masse. Ainsi le connecteur métallique sera relié à la masse du circuit.

Le film plastique 11 comporte en outre sur une de ses faces, dite face de connexion 11a, au moins une piste électriquement conductrice 25.

Dans la réalisation représentée (figure 7), une pluralité de pistes 25 s'étend depuis le bord longitudinal libre 19a' de la partie formant lame 19' jusqu'aux bords libres relevés 22b', 23b' de chaque portion 22', 23'. Les pistes 25 sont réparties de sorte qu'elles recouvrent toute la surface du film plastique 11. Elles sont en outre espacées les unes des autres de sorte qu'elles puissent être superposées aux dents 22a, 23a de l'aile inférieure 20.

Le film plastique 11 est fixé sur la face extérieure 10a de la feuille métallique 10, par sa face 11b ne comportant pas les pistes 25.

On décrit maintenant, en référence aux figures 8a, 8b à 10, l'assemblage du système d'affichage 1 de l'invention.

La partie supérieure 9a du connecteur 9 vient en prise avec le bord de connexion 2d de l'écran d'affichage, de sorte que l'extrémité libre du bord de connexion 2d vienne en butée contre l'âme de maintien 14. La flèche I de la figure 8a montre le sens d'insertion. L'insertion du bord de connexion 2d dans la partie supérieure 9a est guidée par les parois formant guide 16, de manière à assurer notamment une bonne connexion entre les différentes pistes 5i, 25.

En outre, la partie formant lame 19 vient en butée, par son bord longitudinal libre 19a, contre le dispositif de commande 4 de manière à établir la connexion entre ses contacts et les pistes 25 (voir figure 10). Elle permet en outre, grâce à sa forme, d'exercer une pression supplémentaire sur l'écran d'affichage 2.

Il est à noter que l'aile supérieure 12 permet en outre une protection du dispositif de commande 4 contre la lumière et les décharges électrostatiques, arrivant sur l'écran d'affichage 2.

Dans la réalisation représentée figure 10, l'âme de liaison 21 s'étend à proximité de la deuxième plaque de verre 5'.

Enfin, l'aile inférieure 20' du film plastique 11 vient en contact, par son point de contact 24', avec la face 3a du circuit imprimé 3 et exerce une force de réaction F sur celle-ci (figure 2).

Le système d'affichage 1 ainsi assemblé peut aisément être monté à l'intérieur d'un terminal, tel que par exemple un combiné téléphonique (non représenté).

Bien entendu, l'invention n'est pas limitée aux modes de réalisation qui viennent d'être décrits.

## Revendications

1. Connecteur à ressort (9) pour la connexion électrique d'au moins une piste électrique (5i) d'un écran d'affichage (2) avec un circuit électrique (3), comprenant des moyens de maintien (9a) pour maintenir en position l'écran d'affichage et une feuille métallique souple (10), formant ressort,
**caractérisé en ce que** le connecteur à ressort comprend :
- un film plastique (11) comportant au moins une piste électrique (25), et ayant sensiblement la même forme que la feuille métallique,
le film plastique étant fixé à l'une des faces de la feuille métallique, au moins l'une de ses pistes étant destinée à connecter les pistes de l'écran d'affichage avec le circuit électrique.

2. Connecteur à ressort selon la revendication 1, **caractérisé en ce qu'**il présente, en coupe transversale, sensiblement une forme de "S", dont la partie supérieure (9a) forme les moyens de maintien en position de l'écran d'affichage.

3. Système d'affichage (1) comprenant :
- un écran d'affichage (2) comportant au moins une piste électrique (5i);
- un circuit électrique (3) pour commander l'écran d'affichage ;
l'écran d'affichage et le circuit électrique étant disposés sensiblement en regard l'un de l'autre,
**caractérisé en ce qu'**il comprend en outre un connecteur à ressort (9) selon l'une des revendications 1 ou 2.

4. Système d'affichage selon la revendication 3, lorsqu'elle dépend de la revendication 2, **caractérisé en ce que** le connecteur à ressort est disposé de sorte que :
- le film plastique (11) est en contact avec la ou les pistes de l'écran d'affichage et le circuit électrique ;
- la partie supérieure (9a) du "S" formant le connecteur à ressort est en prise avec un bord (5d) de l'écran d'affichage, et
- la partie extrême libre (22b, 23b, 24) de la partie inférieure (9b) du "S" est en contact avec le circuit imprimé et exerce une force de réaction (F) sur ce dernier.

5. Système d'affichage selon la revendication 3 ou 4, **caractérisé en ce qu'**il comprend en outre un dispositif de commande (4) de l'écran d'affichage, fixé sur une face (5b) de l'écran d'affichage et connecté aux pistes (5i) de l'écran d'affichage.

6. Terminal comportant un système d'affichage selon l'une des revendications 3 à 5, **caractérisé en ce qu'**il comprend en outre des moyens de support (6) de l'écran d'affichage et du circuit électrique, et des moyens (7) pour maintenir l'écartement entre l'écran d'affichage et le circuit électrique.

## Claims

1. Spring connector (9) for the electric connecting of at least one electric trace (5i) of a display panel (2) to an electric circuit (3), comprising holding means (9a) to hold the display panel in position and a flexible metal strip (10) forming a spring, **characterized in that** the spring connector comprises:
- a plastic film (11) comprising at least one electric trace (25) and having substantially the same shape as the metal strip,
the plastic film being fixed to one of the sides of the metal strip, at least one of its traces being intended to connect the traces of the display panel to the electric circuit.

2. Spring connector as in claim 1, **characterized in that**, in cross section, it is substantially "S"-shaped, whose upper part (9a) forms means for holding the display panel in position.

3. Display system (1) comprising:
- a display panel (2) comprising at least one electric trace (5i),
- an electric circuit (3) to control the display panel;
the display panel and the electric circuit being arranged substantially facing one another,
**characterized in that** it also comprises a spring connector (9) as in either of claims 1 or 2.

4. Display system as in claim 3, when it is dependent on claim 2, **characterized in that** the spring connector is arranged so that:
- the plastic film (11) is in contact with the trace or traces of the display panel and electric circuit,
- the upper part (9a) of the "S" forming the spring connector is held together with one edge (5d) of the display panel, and
- the free end part (22b, 23b, 24) of the lower part (9b) of the "S" is in contact with the printed circuit and exerts a reaction force (F) on this circuit.

5. Display system as in claim 3 or 4, **characterized in that** it also comprises a control device (4) for the display panel, fixed to one surface (5b) of the display panel and connected to the traces (5i) of the display panel.

6. Terminal comprising a display system as in any of claims 3 to 5, **characterized in that** it also comprises support means (6) to support the display panel and electric circuit, and means (7) for maintaining the space between the display panel and the electric circuit.

## Patentansprüche

1. Federsteckverbinder (9) für die elektrische Verbindung wenigstens einer elektrischen Leiterbahn (5i) eines Bildschirms (2) mit einer Leiterplatte (3), welcher Haltemittel (9a) aufweist, um den Bildschirm an seiner Position zu halten, und ein biegsames metallisches Blatt (10) aufweist, welches die Feder bildet,
**dadurch gekennzeichnet, dass** der Federsteckverbinder aufweist:
einen Kunststofffilm (11) mit wenigstens einer Leiterbahn (25), der im Wesentlichen die gleiche Form wie das metallische Blatt aufweist,
wobei der Kunststofffilm an einer der Seiten des metallischen Blatts befestigt ist, und wobei wenigstens eine Leiterbahn dazu bestimmt ist, die Leiterbahnen des Bildschirms mit der Leiterplatte zu verbinden.

2. Federsteckverbinder gemäß Anspruch 1, **dadurch gekennzeichnet, dass** er im Querschnitt im Wesentlichen die Form eines "S" aufweist, dessen oberer Teil (9a) die Mittel zum Halten des Bildschirms an seiner Position bildet.

3. Anzeigesystem (1), welches aufweist:
einen Bildschirm (2), welcher wenigstens eine Leiterbahn (5i) aufweist;
eine Leiterplatte (3), um den Bildschirm zu steuern;
wobei der Bildschirm und die Leiterplatte im Wesentlichen gegenüber voneinander angeordnet sind,
**dadurch gekennzeichnet, dass** es des Weiteren einen Federsteckverbinder (9) gemäß einem der Ansprüche 1 oder 2 aufweist.

4. Anzeigesystem gemäß Anspruch 3, in Abhängigkeit von Anspruch 2, **dadurch gekennzeichnet, dass** der Federsteckverbinder derart angeordnet ist, dass:
der Kunststofffilm (11) in Kontakt mit der oder den Leiterbahnen des Bildschirms und der Leiterplatte ist;
der obere Teil (9a) des "S", welcher den Federsteckverbinder bildet, mit einer Kante (5d) des Bildschirms zusammenwirkt; und
der freie Endteil (22b, 23b, 24) des unteren Teils (9b) des "S" in Kontakt mit der gedruckten Schaltung ist und auf diese eine Rückstoßkraft (F) ausübt.

5. Anzeigesystem gemäß Anspruch 3 oder 4, **dadurch gekennzeichnet, dass** es des Weiteren eine Vorrichtung zum Steuern (4) des Bildschirms aufweist, an einer Seite (5b) des Bildschirms befestigt ist und mit den Leiterbahnen (5i) des Bildschirms verbunden ist.

6. Endgerät, welches ein Anzeigesystem gemäß einem der Ansprüche 3 bis 5 aufweist, **dadurch gekennzeichnet, dass** es des Weiteren Mittel zum Tragen (6) des Bildschirms und der Leiterplatte sowie Mittel (7) aufweist, um den Abstand zwischen dem Bildschirm und der Leiterplatte zu halten.
